# EUROPÄISCHE PATENTSCHRIFT

(11) **EP 1 439 037 B1**
(45) Veröffentlichungstag und Bekanntmachung des Hinweises auf die Patenterteilung: **01.07.2015**
(21) Anmeldenummer: 03104755.8
(22) Anmeldetag: 17.12.2003
(51) Int. Cl.: B25D 17/00, B25F 5/00, H01H 9/00

(54) **Elektrohandwerkzeugmaschine mit kontaktlosem elektrischen Handschalter**
Electrical hand tool machine with contactless electrical manual switch
Machine-outil électrique à main avec commutateur manuel électrique sans contact

(30) Priorität: 19.12.2002 DE 10259569
(43) Veröffentlichungstag der Anmeldung: 21.07.2004
(73) Patentinhaber: HILTI Aktiengesellschaft, 9494 Schaan (LI)
(72) Erfinder: Kristen, Ferdinand, 82205, Gilching (DE); Manschitz, Erwin, 82110, Germering (DE); Pfisterer, Hans-Jürgen Horst Georg, 82110, Germering (DE)
(74) Vertreter: Hilti Aktiengesellschaft Corporate Intellectual Property

(56) Entgegenhaltungen:
- DE-A1- 4 401 664
- DE-C1- 19 756 857
- GB-A- 2 314 288

## Beschreibung

Die Erfindung bezeichnet eine Elektrohandwerkzeugmaschine mit einem kontaktlosen elektrischen Handschalter, insbesondere einen zumindest teilweise schlagenden Meisselhammer oder Kombihammer, wie aus der GB 2 314 288 und dem Oberbegriff von Anspruch 1 bekannt.

Bei Elektrohandwerkzeugmaschinen, welche bedingt durch ihre zweckentsprechende Benutzung sowohl hohen Staubbelastungen als auch starken Vibrationen ausgesetzt sind, unterliegen mechanische Kontaktschalter einem hohen Verschleiss.

Nach der US5014793 wird eine Elektrohandwerkzeugmaschine über einen Handschalter gesteuert, dessen Betätigungsmittel mechanisch Piezosensoren zur Ansteuerung eines Leistungsschalters betätigt. Die Drucksensoren sind notwendigerweise mit dem Betätigungsmittel in mechanischem Kontakt, wodurch Vibrationen auf den Betätigungsmittel übertragbar sind.

Nach der DE4401664 weist ein Kombihammer mit einem kontaktlosen elektrischen Handschalter einen, dem Betätigungsmittel direkt, nach der DE19942156 über ein Schaltgestänge steuerbar zugeordneten, kontaktlosen elektrischen Hall-Sensorschalter auf, welcher vibrationsfrei über das Gehäuse mit dem Betätigungsmittel verbunden ist. Dazu muss der Sensorschalter mit dem Gehäuse verbunden sein.

Die Aufgabe der Erfindung besteht in der Realisierung eines technologisch einfachen, kontaktlosen elektrischen Handschalters, dessen Sensorschalter bezüglich des Betätigungsmittels vibrationsunempfindlich ist.

Die Aufgabe wird durch die Merkmale des unabhängigen Ansprüchs 1 gelöst. Vorteilhafte Weiterbildungen ergeben sich aus den Unteransprüchen.

Im Wesentlichen weist eine Elektrohandwerkzeugmaschine mit einer längs einer Vibrationsachse vibrierenden Baugruppe einen kontaktlosen elektrischen Handschalter mit einem Betätigungsmittel und einem Sensorschalter auf, wobei der Sensorschalter vibrationsfrei mit einem zumindest schwenkbaren Schaltmittelträger verbunden ist, dessen Schwenkachse längs der Vibrationsachse orientiert ist und welcher über ein längs der Vibrationsachse begrenzt axial bewegliches Schwenkübertragungsmittel vom Betätigungsmittel händisch steuerbar ist.

Durch den vom längs der Vibrationsachse begrenzt axial beweglichen Betätigungsmittel händisch steuerbaren, bezüglich des Sensorschalters vibrationsfreien Schaltmittelträger besteht eine Vibrationsentkopplung zwischen dem Betätigungsmittel und dem Sensorschalter, wodurch dieser gegenüber dem Gehäuse vibrieren kann, ohne die Schaltfunktion des Sensorschalters oder des Betätigungsmittels negativ zu beeinflussen.

Vorteilhaft bildet der Schaltmittelträger mit dem Betätigungsmittel eine Drehschwenkkupplung aus, weiter vorteilhaft in Form eines aus dem Schaltmittelträger axial exzentrisch auskragenden Kupplungspins, der in eine Kupplungsführung des Betätigungsmittels eingreift, wodurch der kontaktlose elektrische Handschalter mit einem im Gehäuse der Elektrohandwerkzeugmaschine versetzbar geführten Betätigungsmittel erst bei der Endmontage zusammengesetzt wird.

Vorteilhaft erfolgt durch eine entsprechende Geometrie der Kupplungsführung eine Bewegungstransformation zwischen dem Betätigungsmittel und dem Schaltmittelträger, wodurch bspw. mit einer Kupplungsführung in Form eines Führungsschlitzes ein quer zur Vibrationsachse versetzbarer Schiebeschalter einfach realisierbar ist.

Vorteilhaft ist der Sensorschalter direkt in einer Motorsteuerelektronik eingegossen, wodurch der Sensorschalter integrierter Bestandteil einer schwingungsunempfindlichen Motorsteuerelektronik ist, welche optional zur Schwingungsmasse der vibrierenden Baugruppe beiträgt.

Vorteilhaft ist der Schaltmittelträger als beidseitig begrenzt drehschwenkbare Schwenkwippe ausgebildet, wodurch ein quer zur Schwenkachse beabstandetes Schaltmittel nur innerhalb eines durch zwei Endpositionen begrenzten Kreisbogenbereich versetzbar ist, die Schaltpositionen zuordenbar sind.

Vorteilhaft ist der Schaltmittelträger bezüglich des Sensorschalters in zumindest einer Schaltposition stabil, weiter vorteilhaft in genau zwei Schaltpositionen bistabil, elastisch vorgespannt, wodurch die Schaltpositionen vibrationsunempfindlich sind.

Vorteilhaft ist zwischen dem Schaltmittelträger und dem Sensorschalter eine Blattfeder zur Vorspannung der Schaltposition angeordnet, welche technologisch einfach herstellbar ist. Vorteilhaft ist das Schaltmittel als Permanentmagnet und der Sensorschalter als Hall-Sensorschalter ausgeführt, welche staubunempfindlich sind.

Die Erfindung wird bezüglich eines vorteilhaften Ausführungsbeispiels näher erläutert mit:
- Fig. 1: als Ausschnitt einer vibrierenden Elektrohandwerkzeugmaschine
- Fig. 2: als Einzelheit des kontaktlosen Handschalters, gesehen entsprechend Linie II-II auf Fig. 1

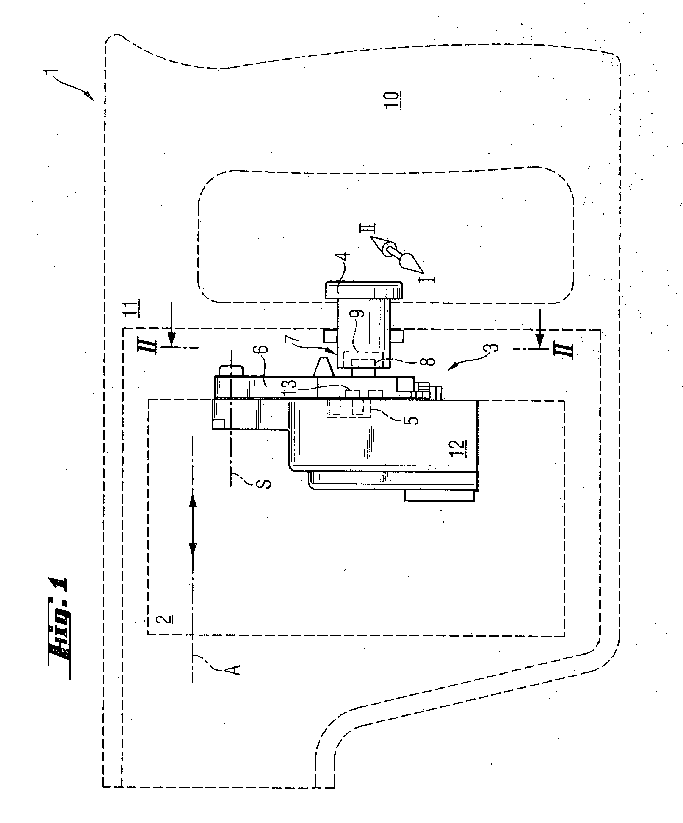

Nach Fig. 1 weist eine nur angedeutete, schlagende Elektrohandwerkzeugmaschine 1 mit einer längs einer Vibrationsachse A vibrierenden Baugruppe 2 einen kontaktlosen elektrischen Handschalter 3 mit einem Betätigungsmittel 4 und einem Sensorschalter 5 auf. Der Sensorschalter 5 ist vibrationsfrei mit einem drehschwenkbaren Schaltmittelträger 6 verbunden, dessen Schwenkachse S parallel zur Vibrationsachse A orientiert ist. Über ein längs der Vibrationsachse A begrenzt axial bewegliches Schwenkübertragungsmittel 7 in Form einer Drehschwenkkupplung mit einem aus dem Schaltmittelträger 6 axial exzentrisch auskragenden Kupplungspin 8, welcher in eine Kupplungsführung 9 des Betätigungsmittels 4 eingreift, ist der Handschalter 3 manuell von einem Handgriff 10 des Gehäuses 11 der Elektrohandwerkzeugmaschine 1 ausgehend betätigbär. Durch das senkrecht zur Darstellungsebene versetzbare Betätigungsmittel 4 in Form eines Schiebeschalters erfolgt über die Kupplungsführung 9 in Form eines radial zur Schwenkachse S verlaufenden Führungsschlitzes eine Bewegungstransformation zwischen dem linear begrenzt versetzbaren Betätigungsmittel 4 und dem drehschwenkbaren Schaltmittelträger 6. Der Sensorschalter 5 ist mit der vibrierenden Baugruppe 2 verbunden, indem er direkt in einer schwingungsunempfindlichen Motorsteuerelektronik 12 eingegossen ist, die zur Schwingungsmasse der vibrierenden Baugruppe 2 beiträgt.

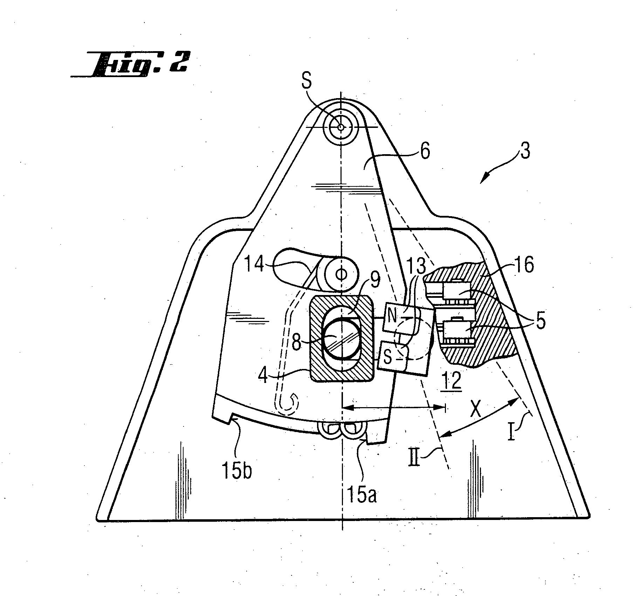

Nach Fig. 2 ist der Schaltmittelträger 6 als beidseitig begrenzt drehschwenkbare Schwenkwippe mit einem quer zur Schwenkachse S beabstandeten Schaltmittel 13 in Form zweier antiparallel orientierter Permanentmagnete ausgebildet. Der Schaltmittelträger 6 ist bezüglich des Sensorschalters 5 über eine Blattfeder 14 in beiden Schaltpositionen EIN / AUS bistabil elastisch vorgespannt. Der Schaltmittelträger ist durch Endanschläge 15a, 15b nur innerhalb eines durch die beiden zugeordneten Endpositionen I, II begrenzten Kreisbogenbereiches X gegenüber dem als differentiellen Hall-Sensorschalter ausgebildeten Sensorschalter 5 versetzbar, der in einer Vergussmasse 16 der Motorsteuerung 12 eingegossen ist.

## Patentansprüche

1. Elektrohandwerkzeugmaschine die eine längs einer Vibrationsachse (A) vibrierende Baugruppe (2) und einen kontaktlosen elektrischen Handschalter (3) aufweist, wobei der Handschalter (3) ein Betätigungsmittel (4), einen Sensorschalter (5) und einen zumindest schwenkbaren Schaltmittelträger (6) aufweist und der Schaltmittelträger (6) über ein längs der Vibrationsachse (A) begrenzt axial bewegliches Schwenkübertragungsmittel (7) vom Betätigungsmittel (4) händisch steuerbar ist,
**dadurch gekennzeichnet, dass**
der Sensorschalter (5) mit der vibrierenden Baugruppe (2) verbunden und bezüglich des Schaltmittelträgers (6) vibrationsfrei mit dem Schaltmittelträger (6) verbunden ist und eine Schwenkachse (S) des Schaltmittelträgers (6) längs der Vibrationsachse (A) orientiert ist.

2. Elektrohandwerkzeugmaschine nach Anspruch 1, **dadurch gekennzeichnet, dass** der Schaltmittelträger (6) mit dem Betätigungsmittel (4) eine Drehschwenkkupplung (7) ausbildet, optional in Form eines aus dem Schaltmittelträger (6) axial exzentrisch auskragenden Kupplungspins (8), der in eine Kupplungsführung (9) des Betätigungsmittels (4) eingreift.

3. Elektrohandwerkzeugmaschine nach Anspruch 1 oder 2, **dadurch gekennzeichnet, dass** durch eine entsprechende Geometrie der Kupplungsführung (9) eine Bewegungstransformation zwischen dem Betätigungsmittel (4) und dem Schaltmittelträger (6) erfolgt.

4. Elektrohandwerkzeugmaschine nach einem der Ansprüche 1 bis 3, **dadurch gekennzeichnet, dass** der Sensorschalter (5) direkt in einer Motorsteuerelektronik (12) eingegossen ist.

5. Elektrohandwerkzeugmaschine nach einem der vorherigen Ansprüche, **dadurch gekennzeichnet, dass** der Schaltmittelträger (6) als beidseitig begrenzt drehschwenkbare Schwenkwippe ausgebildet ist.

6. Elektrohandwerkzeugmaschine nach einem der vorherigen Ansprüche, **dadurch gekennzeichnet, dass** der Schaltmittelträger (6) bezüglich des Sensorschalters (5) in zumindest einer Schaltposition stabil ist, optional in genau zwei Schaltpositionen bistabil.

7. Elektrohandwerkzeugmaschine nach Anspruch 6, **dadurch gekennzeichnet, dass** zwischen dem Schaltmittelträger (6) und dem Sensorschalter (5) eine Blattfeder (14) zur Vorspannung der Schaltposition angeordnet ist.

8. Elektrohandwerkzeugmaschine nach einem der vorherigen Ansprüche, **dadurch gekennzeichnet, dass** das Schaltmittel (13) als Permanentmagnet und der Sensorschalter (5) als Hall- Sensorschalter ausgeführt ist.

## Claims

1. Hand-held power tool which has a sub-assembly (2) vibrating along an axis of vibration (A) and a contactless manual electrical switch (3), the manual switch (3) having an actuating means (4), a switch in sensor form (5) and an at least pivotable switching means carrier (6) and the switching means carrier (6) being controllable manually by the actuating means (4) via a transmission means (7) for pivoting movement which has limited axial mobility in the direction defined by the axis of vibration (A), **characterised in that** the switch in sensor form (5) is connected to the vibrating sub-assembly (2) and is connected to the switching means carrier (6) to be free of vibration relative to the said switching means carrier (6), and an axis of pivot (S) of the switching means carrier (6) is orientated along or alongside the axis of vibration (A).

2. Hand-held power tool according to claim 1, **characterised in that** the switching means carrier (6) forms, with the actuating means (4), a coupling for rotary pivoting movement (7), optionally in the form of a coupling pin (8) which projects axially and eccentrically from the switching means carrier (6) and which engages in a coupling guideway (9) in the actuating means (4).

3. Hand-held power tool according to claim 1 or 2, **characterised in that**, as a result of an appropriate geometry for the coupling guideway (9), a conversion of motion takes place between the actuating means (4) and the switching means carrier (6).

4. Hand-held power tool according to one of claims 1 to 3, **characterised in that** the switch in sensor form (5) is moulded directly into an electronic unit (12) for motor control.

5. Hand-held power tool according to one of the preceding claims, **characterised in that** the switching means carrier (6) takes the form of a pivoting swinger which has limited rotary pivotability in both directions.

6. Hand-held power tool according to one of the preceding claims, **characterised in that** the switching means carrier (6) is stable relative to the switch in sensor form (5) in at least one switching position and, as an option, in precisely two switching positions.

7. Hand-held power tool according to claim 6, **characterised in that** a leaf spring (14) for pre-loading to the switching position is arranged between the switching means carrier (6) and the switch in sensor form (5).

8. Hand-held power tool according to one of the preceding claims, **characterised in that** the switching means (13) takes the form of a permanent magnet or magnets and the switch in sensor form (5) that of a switch in Halleffect sensor form.

## Revendications

1. Machine-outil électrique à main comportant un ensemble (2) vibrant le long d'un axe de vibration (A) et un commutateur électrique manuel sans contact (3), dans laquelle le commutateur manuel (3) comporte un moyen d'actionnement (4), un contacteur de détection (5) et un support de moyen de commutation au moins pivotant (6) et dans laquelle le support de moyen de commutation (6) peut être commandé manuellement à partir du moyen d'actionnement (4) par l'intermédiaire d'un moyen de transmission de pivotement (7) qui peut se déplacer axialement de manière limitée le long de l'axe de vibration (A),
**caractérisée en ce que** le contacteur de détection (5) est relié à l'ensemble vibrant (2) et est relié au support de moyen de commutation (6) de manière non vibrante par rapport au support de moyen de commutation (6), et **en ce qu'**un axe de pivotement (S) du support de moyen de commutation (6) est orienté le long de l'axe de vibration (A).

2. Machine-outil électrique à main selon la revendication 1, **caractérisée en ce que** le support de moyens de commutation (6) forme un couplage pivotant en rotation avec le moyen d'actionnement (4), facultativement sous la forme d'une goupille de couplage (8) faisant saillie vers l'extérieur de manière axialement excentrée à partir du support de moyen de commutation (6), laquelle goupille de couplage s'engage dans un guide de couplage (9) du moyen d'actionnement (4).

3. Machine-outil électrique à main selon la revendication 1 ou 2, **caractérisée en ce qu'**une transformation de mouvement s'effectue entre le moyen d'actionnement (4) et le support de moyen de commutation (6) au moyen d'une géométrie correspondante du guide de couplage (9).

4. Machine-outil électrique à main selon l'une des revendications 1 à 3, **caractérisée en ce que** le contacteur de détection (5) est directement intégré dans une électronique de commande de moteur (12).

5. Machine-outil électrique à main selon l'une des revendications précédentes, **caractérisée en ce que** le support de moyen de commutation (6) est formé comme une bascule pouvant pivoter de manière limitée de deux côtés.

6. Machine-outil électrique à main selon l'une des revendications précédentes, **caractérisée en ce que** le support de moyen de commutation (6) est stable par rapport au contacteur de détection (5) dans au moins une position de commutation, facultativement bistable dans exactement deux positions de commutation.

7. Machine-outil électrique à main selon la revendication 6, **caractérisée en ce qu'**un ressort à lame (14) est agencé entre le support de moyens de commutation (6) et le contacteur de détection (5) pour précontrainte dans la position de commutation.

8. Machine-outil électrique à main selon l'une des revendications précédentes, **caractérisée en ce que** le moyen de commutation (13) est réalisé sous la forme d'un aimant permanent et le contacteur de détection (5) est réalisé sous la forme d' un contacteur de détection à effet Hall.
